# EUROPEAN PATENT APPLICATION

(11) **EP 2 239 759 A2**
(43) Date of publication of application: **13.10.2010**
(21) Application number: 09014045.0
(22) Date of filing: 10.11.2009
(51) Int. Cl.: H01J 37/32

(54) **Substrate treatment apparatus, substrate treatment method, preliminary electrode structure, measuring electrode structure, and process electrode structure**

(30) Priority: 06.04.2009 KR 20090029424
(71) Applicant: Korea Advanced Institute of Science and Technology, Daejeon 305-701 (KR)
(72) Inventor: Chang, Hong-Young, Daejeon, 305-701 (KR); Lee, Hun-Su, Daejeon, 305-701 (KR)
(74) Representative: Harrison, Michael Robert

(57) **Abstract**

Provided are a substrate treatment method, a substrate treatment apparatus, a preliminary electrode structure, and a process electrode structure. The substrate treatment method includes selecting a shape of a hole by confirming at least one of plasma characteristics and a process result based on the shape of a hole with the use of a preliminary electrode structure where holes are formed to have shapes varying with positions; selecting an optimal process position by treating a substrate with the use of a measuring electrode structure where density of the hole varies with positions; providing a process electrode structure by transferring a hole of the measuring electrode structure corresponding to the optimal process position; and compensating process nonuniformity based on positions with the use of the process electrode structure.

## Description

### CROSS-REFERENCE TO RELATED APPLICATIONS

This European patent application claims priority to Korean Patent Application No. 10-2009-0029424, filed on April 6, 2009, the entirety of which is hereby incorporated by reference.

### BACKGROUND

### Technical Field

The present invention relates to substrate treatment methods and, more particularly, to a substrate treatment method capable of rapidly searching optimal process conditions of a substrate treatment apparatus.

### Description of Related Art

A plasma substrate treatment apparatus has been applied to various processes such as etching, deposition, ion implantation, and material surface treatment. A plasma substrate treatment apparatus has been used in processes of semiconductor substrates, flat panel display substrates, and solar cell substrates. With the recent demands for scaling-up of substrates and fine treatment of substrates, a lot of costs and time are required to search uniform, optimal process conditions of a plasma substrate treatment apparatus.

### SUMMARY

Exemplary embodiments of the present invention provide a substrate treatment method.

In some exemplary embodiments, the substrate treatment method may include selecting a shape of a hole by confirming at least one of plasma characteristics and a process result based on the shape of a hole with the use of a preliminary electrode structure where holes are formed to have shapes varying with positions; selecting an optimal process position by treating a substrate with the use of a measuring electrode structure where density of the hole varies with positions; providing a process electrode structure by transferring a hole of the measuring electrode structure corresponding to the optimal process position; and compensating process non-uniformity based on positions with the use of the process electrode structure.

In some exemplary embodiments, the substrate treatment method may include selecting an optimal process position by treating a substrate with the use of a measuring electrode structure where density of a hole varies with positions; providing a process electrode structure by transferring density of a hole of the measuring electrode structure corresponding to the optimal process position; and compensating process non-uniformity based on positions with the use of the process electrode structure..

Exemplary embodiments of the present invention provide a substrate treatment apparatus, a preliminary electrode structure, and a process electrode structure.

In some exemplary embodiments, the substrate treatment apparatus may include a treatment container; a process electrode structure disposed on a wall of the treatment container or disposed inside the treatment container; a power source applying a power to the process electrode structure to generate plasma inside the treatment container; and a substrate holder disposed to face the process electrode structure and configured to hold a substrate. The process electrode structure has hole density varying with positions.

In some exemplary embodiments, the preliminary electrode structure may include a first preliminary electrode; and a second preliminary electrode disposed on one surface of the first preliminary electrode. The first preliminary electrode holes whose shapes vary with positions. The first and second preliminary electrodes are electrically connected to each other, a power is applied to the second preliminary electrode to generate plasma below the first preliminary electrode, and plasma density varying with the shape of a hole of the first preliminary electrode is made under a process condition to select an optimal shape of the hole.

In some exemplary embodiments, the measuring electrode structure may include unit measuring electrode patterns having a plurality of holes. Each of the unit measuring electrode patterns includes a plurality of split areas where densities of holes vary with positions. The split areas make different plasma densities based on hole density varying with positions to provide a non-uniform process according to the hole density.

In some exemplary embodiments, the process electrode structure may include at least one unit process electrode pattern having a plurality of holes. The unit process electrode pattern make uniform plasma density based on hole density varying with positions to provide a uniform process according to the hole density.

### BRIEF DESCRIPTION OF THE DRAWINGS

The present invention will become more apparent in view of the attached drawings and accompanying detailed description. The embodiments depicted therein are provided by way of example, not by way of limitation, wherein like reference numerals refer to the same or similar elements. The drawings are not necessarily to scale, emphasis instead being placed upon illustrating aspects of the invention.

FIGS. 1 and 2 are flowcharts illustrating a substrate treatment method according to an embodiment of the present invention.

FIGS. 3 to 6 illustrate a substrate treatment apparatus including a preliminary electrode structure according to embodiments of the present invention.

FIGS. 7 and 8 are a plan view and a sectional view of a measuring electrode structure according to an embodiment of the present invention, respectively.

FIG. 9 is a top plan view illustrating a deposition rate when a process is performed for a substrate by using the measuring electrode structure shown in FIG. 7.

FIGS. 10 and 11 are a top plan view and a cross-sectional view of a process electrode structure according to an embodiment of the present invention, respectively.

FIGS. 12 to 14 are perspective views of a process electrode structure according to embodiments of the present invention.

FIGS. 15 and 16 are top plan views of a measuring electrode structure according to embodiments of the present invention.

FIGS. 17 and 18 are perspective views of a process electrode structure according to embodiments of the present invention.

FIGS. 19 to 22 are cross-sectional views of a substrate treatment apparatus according to embodiments of the present invention.

FIGS. 23A to 23C illustrate a substrate treatment method according to another embodiment of the present invention.

### DETAILED DESCRIPTION OF THE EMBODIMENTS

Various processes for mass production of semiconductors or solar cell have been scaled up to enhance process efficiency and finer processes have been tried to achieve high performance. Due to the trend toward scaling-up and finer processes, process uniformity is increasingly becoming significant. For example, a process chamber may suffer from structural non-uniformity caused by a number of internal factors such as load-lock, a view port, and a vacuum pumping port. Like an antenna of inductively coupled plasma in which the energy transfer amount by capacitive coupling varies with position, means for applying energy or fluid may not accomplish uniform distribution of elements to be applied.

In order to achieve uniformity of a process, there is an ideal attempt to make all elements associated with the process uniform according to positions. However, properties of the process make it difficult to apply such a trial to a practical process.

In view of the foregoing, the present invention provides a method of overcoming non-uniformity of a process at high speed and low cost. When other process elements are non-uniformly distributed, one or a plurality of process elements may be non-uniformly interposed therebetween by intention to achieve a uniform process. Thus, the non-uniformity is canceled to improve the process.

Various approaches have been taken to cancel non-uniformity of a process. One of the approaches is that uniformity is improved to a desired level by means of computer simulation. However, as a high-level uniformity is required, an allowable range of a difference between a computer simulation result and a practical process result is reduced to increase difficulty of simulation as well as cost and time required for correction. As a result, the degree of improvement is reduced when this approach is applied.

Another approach is that desired uniformity is achieved through a number of trials and errors by performing a process while changing a process chamber structure/material or energy/material apply means. However, cost and time required for modification are considerably exhausted during the trials and errors. Further, in the case where a process area is altered during a process, considerable time and material cost are also exhausted in modification.

Therefore, the present invention provides a method of improving process uniformity. The method uses concepts of "measuring pattern structure" and "process pattern structure" in which there is one or more unit patterns at each position and each of the unit patterns is configured to continuously or discontinuously change elements associated with a process according to positions within a pattern, allowing a result of the process to be different. According to the method, a process is corrected using the concepts to make the process uniform. Thus, uniformity of a plurality of chambers is systemically improved at low time/physical costs.

First, a process is performed by coupling a measuring pattern structure with a chamber to achieve improvement of the process. At this point, because process elements vary with positions at each unit pattern, a spot where a process is performed to a desired extent may locally exist according to positions on unit patterns. A process pattern structure may be fabricated such that process elements of a corresponding local position on each pattern are transferred to the whole pattern area. Thus, process uniformity of the chamber may be improved.

When a process is corrected by means of the above-mentioned manner, uniformity of a chamber may be optimally improved only by coupling of a measuring pattern structure, observation of a process and a process result based on position, and construction of a process pattern structure. As a result, time and cost are considerably reduced.

The measuring pattern structure may be fabricated by combining previously formed patterns to be applied to various process conditions and correction of a plurality of chambers. As a result, correction cost may be further reduced.

Such a correction is more efficient when variation of process elements on a local position leads to variation of a process result at a narrow area adjacent to a corresponding local position, a pattern size is determined such that non-uniformity on each pattern area is not high, and a pattern is formed to minutely vary within the range where a variation range of elements on the pattern meets a range of elements for uniformity.

A power may be applied to an electrode disposed at a chamber. The electrode may generate plasma. When a plurality of holes are formed at the electrode to which the power is applied, the intensity and direction of an electric field established around the hole may vary with a pressure and a voltage applied to perform a process. In the case where there is a hole having diameter and depth within a suitable range, electron density (plasma density) may increase or decrease around the hole. The hole may cause hollow cathode discharge.

Using this phenomenon, a hole having suitable diameter and/or depth may be formed at an electrode or a wall of a chamber to which a power is applied. Thus, electron density may be improved around the hole or plasma parameters may be controlled.

A suitable hole size may be theoretically calculated from information on length of a sheath and/or temperature of electrons. However, there is a limitation in theoretically calculating plasma parameters according to the kind of a process gas and determining a type of a hole using the plasma parameters.

A preliminary electrode structure may include various types (diameter, depth, taper angle) of holes. Each of the holes may have a cross section that is circular, tetragonal, polygonal, star-shaped or elliptical. Alternatively, each of the holes may be a trench-shaped hole. The preliminary electrode structure including the holes may be mounted at a chamber. A process for a substrate may be performed using the preliminary electrode within predetermined process pressure range, power range, and process gas range. In this case, only a part of the holes may emit light and/or plasma density may be improved within the predetermined process range. A shape of a hole emitting brightest light or exhibiting an optimal process result may be selected. The shape of the light-emitting hole may be determined by means of optical emission spectroscopy (OES) or naked eye. The optimal process result may be confirmed by an apparatus for analyzing the substrate.

Using this phenomenon, in a plasma generator where uniform plasma discharge and/or uniform process are not performed, density of holes may increase or decrease at a low plasma density zone to make plasma density uniform. Thus, plasma uniformity and/or process uniformity may be improved at the plasma generator.

In the case where a substrate treatment apparatus is manufactured with a design, it may be subjected to a tuning procedure to be applied to practical mass production. For example, when a silicon is deposited on a substrate by means of plasma enhanced chemical vapor deposition (PECVD), a process deviating from predetermined uniformity may be performed in a specific recipe. As an area of a substrate continues to increase, it may be difficult to secure the silicon deposition uniformity even when fine tuning of the recipe is done. In this case, a silicon deposition process may be performed under the condition of the recipe by using the preliminary electrode structure. Accordingly, an optimal shape of a hole formed at the preliminary electrode structure may be selected. Thereafter, a silicon deposition process may be performed with the selected shape of the hole under the condition of the recipe by using a measuring electrode structure where hole density varies with position. A process electrode structure reflecting the hole density varying with position may provide uniformity of the silicon deposition.

The present invention will now be described more fully hereinafter with reference to the accompanying drawings, in which preferred embodiments of the invention are shown. This invention, however, may be embodied in many different forms and should not be construed as limited to the embodiments set forth herein. Rather, these embodiments are provided so that this disclosure will be thorough and complete, and will fully convey the scope of the invention to those skilled in the art. In the drawings, the thicknesses of layers and regions are exaggerated for clarity. It will also be understood that when a layer is referred to as being "on" another layer or substrate, it can be directly on the other layer or substrate, or intervening layers may also be present. Like numbers refer to like elements throughout.

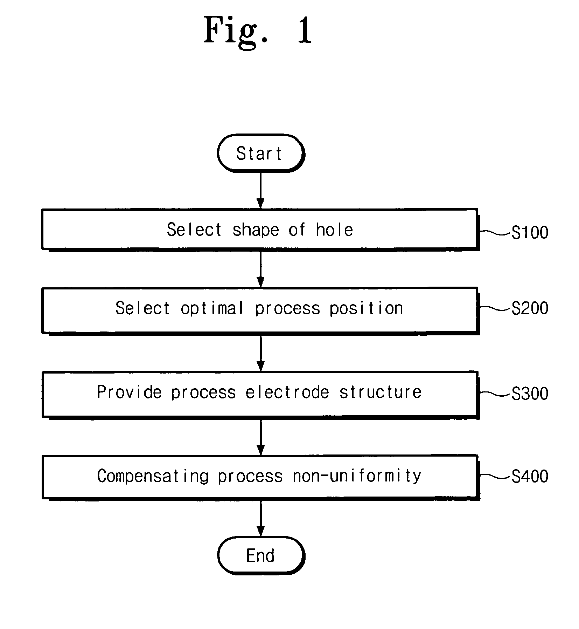

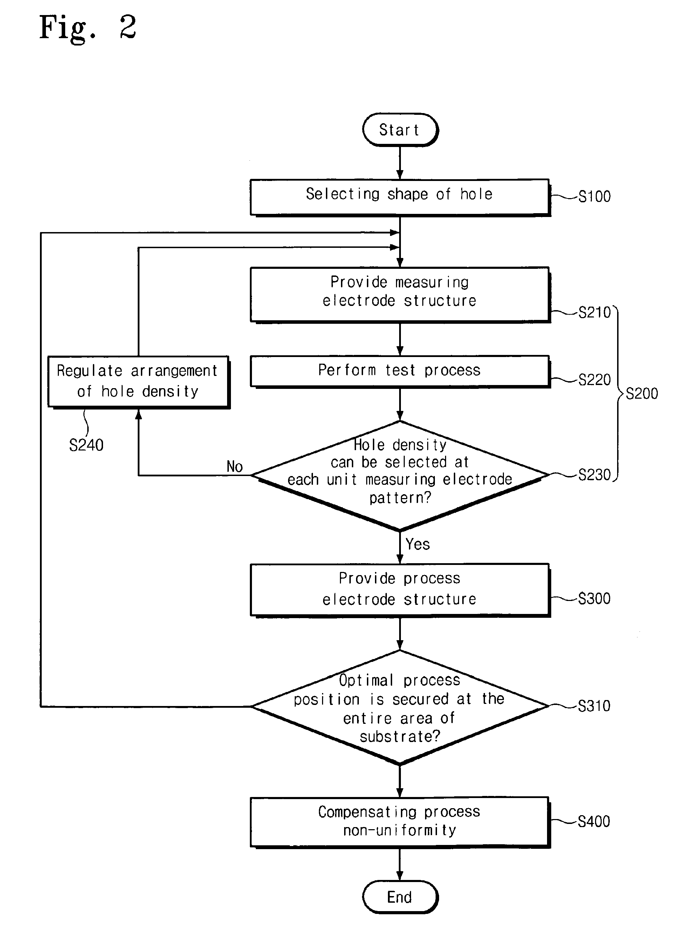

FIGS. 1 and 2 are flowcharts illustrating a substrate treatment method according to an embodiment of the present invention.

As illustrated, the substrate treatment method includes steps S100, S200, S300, and S400. At step S100, a shape of a hole is selected by confirming at least one of plasma characteristics and a process result based on the shape of a hole. The conformation is done with the use of a preliminary electrode structure where holes are formed to have shapes varying with positions. At step S200, an optimal process position is selected by treating a substrate according to the selected shape of a hole. The substrate treatment is done with the use of a measuring electrode structure where density of the hole varies with position. At step S300, a process electrode structure is provided by transferring the density of the hole of the measuring electrode structure corresponding to the optimal process position. At step S400, the process electrode structure may compensate process non-uniformity.

The substrate may include a semiconductor substrate, a dielectric substrate, a cloth, and a metal. The substrate may be any one of materials that may be treated with plasma. The substrate may be a flexible material. The discharge may be DC discharge, AC discharge, RF discharge or super-high frequency discharge. The discharge may be capacitively coupled discharge. A pressure of the discharge may be an atmospheric pressure, vacuum or a high pressure above the atmospheric pressure. The discharge may not be limited to the case where a vacuum container is provided. The plasma treatment may include etching, deposition, ion implantation, surface treatment or sterilization. The discharge is not limited to the case where a power is directly applied to the preliminary electrode structure, the measuring electrode structure, and the process electrode structure. The preliminary electrode structure, the measuring electrode structure, and the process electrode structure may be used as a ground electrode, and a separate electrode to which a power is applied may be disposed.

The preliminary electrode structure may have a hole shape varying with position. At least one of depth, diameter, and taper angle of holes of the preliminary electrode structure may vary with position of the holes. The hole may lead to hollow cathode discharge. The discharge may be conducted using the preliminary electrode structure to select a hole shape of improved electron density (plasma density) and/or process result. The discharge may be conducted within the range of temperature of a substrate where a practical process is to be performed, process gas, a power applied to a preliminary electrode structure.

The hole shape selected using the preliminary electrode structure may be reflected on the measuring electrode structure. The measuring electrode structure may include holes arranged to have density varying with position (S210). The measuring electrode structure may include at least one unit measuring electrode pattern. The unit measuring electrode pattern may include a plurality of split areas having hole density varying with position.

A method of fabricating the measuring electrode structure (S210) may include combining pre-formed unit measuring electrode patterns after determining a hole shape according to a chamber or a process. Alternatively, the measuring electrode structure may be fabricated by directly forming the unit process electrode patterns at a base substrate electrode.

Modified embodiments of the present invention may employ a continuous arrangement manner where holes are arranged while their density gradually varies with position.

The substrate may be treated using the measuring electrode structure to perform a test process (S220). A result of the test process depending on the hole density may be confirmed to select an optimal process position of the substrate. The optimal process position of the substrate may have the same meaning as an optimal process position of the measuring electrode structure. The measuring electrode structure may include at least one unit measuring electrode pattern. The unit measuring electrode patterns may exhibit the same shape. In the case where it is expected that a process difference will arise according to positions, the unit measuring electrode pattern may include different split combinations. That is, the unit measuring electrode patterns may be configured to be different based on an expected process degree according to positions.

The unit measuring pattern may include a plurality of split areas, which may have different hole densities. The split areas may induce plasma characteristics and/or process characteristics varying with local positions. The optimal process position may be selected at the respective unit measuring electrode patterns (S230).

The optimal process position may be positions where the same result is reached at the respective unit measuring electrode patterns. That is, a predetermined split area may be selected as the optimal process position at the respective unit measuring patterns. Thus, the selected split areas may provide the same process result.

Alternatively, the optima process position may be selected at the respective split areas of the unit measuring electrode pattern (S230). The optimal process position may be an area that is selectively designated at each of the split areas.

In the case where all the unit measuring patterns do not include a position where a process was performed to meet predetermined conditions (S2530), the entire hole density of the measuring electrode structure may increase or decrease (S240). In the case where only a desired process is performed at not all the unit measuring patterns but a part of the unit measuring patterns, the measuring electrode structure may increase or decrease a difference in hole density between splits of the unit measure patterns (S240).

The process electrode structure may include at least one unit process electrode pattern. The unit process electrode pattern may have the density of holes corresponding to a position selected at each of the unit measuring electrode patterns. That is, the density of holes at the optimal process position may be transferred to the unit process electrode pattern (S300). As a result, the process electrode structure may have a density array of holes of the measuring electrode structure corresponding to the optimal process position throughout its area. The process electrode structure may be fabricated by combining the unit process electrode patterns which are separated from each other. Alternatively, the process electrode structure may be configured to form the unit process electrode patterns at a base substrate electrode.

The optimal process position may be an area that is selectively designated at each of the split areas. That is, when a process electrode structure is transferred, an optimal process zone on a split varying with position may also be selected on the unit measuring electrode pattern. In this case, position and width of the unit process electrode pattern may be properly designated.

In the case where a process is performed using the process electrode structure, it may not reach a desired degree of process due to interference effect of an adjacent zone. In this case, the measuring electrode structure and/or the process electrode structure may be re-fabricated by feeding back the process result of the process electrode structure (S310). The process electrode structure may compensate process non-uniformity based on positions (S400).

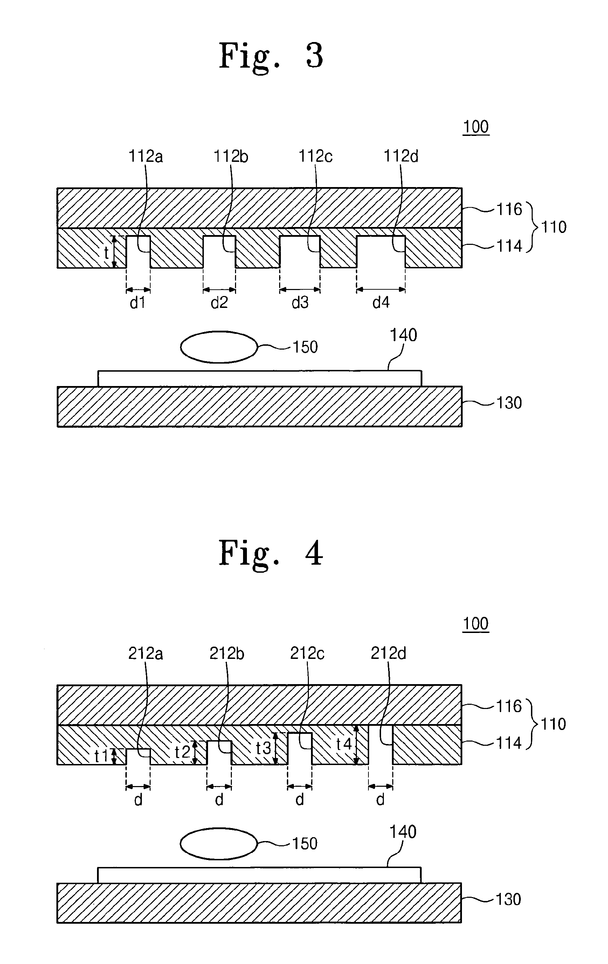

FIGS. 3 to 6 illustrate a substrate treatment apparatus 100 including a preliminary electrode structure according to embodiments of the present invention.

Referring to FIG. 3, the substrate treatment apparatus 100 include a preliminary electrode structure 110 and a substrate holder 130. A substrate 140 may be disposed on the substrate holder 130. The preliminary electrode structure 110 may include a first preliminary electrode 114 and a second preliminary electrode 116 disposed on one surface of the first preliminary electrode 114. The first preliminary electrode 114 may include holes whose shapes are different according to positions. The first and second preliminary electrodes 114 and 116 may be electrically connected to each other. Plasma 150 may be generated below the first preliminary electrode 114 by applying an RF power to the second preliminary electrode 116. Under a predetermined process condition, the shape of a hole of the first preliminary electrode 114 may allow plasma density and/or a process result to be varied. Therefore, an optimal shape of a hole may be selected by examining the plasma density and/or the process result.

The first preliminary electrode 114 may include a plurality of holes 112a∼112d whose diameters are different from each other. Diameters d1, d2, d3, and d4 of the holes 112a∼112d may increase in the order named. The holes 112a∼112d may have the same depth (t), which may be smaller than that of the first preliminary electrode 114.

The plasma 150 generated by the preliminary electrode structure 110 may be dependent upon a process pressure, a process gas, and an applied power. The holes 112a∼112d may provide hollow cathode discharge. The holes 112a∼112d may provide plasma density varying with the diameters d1, d2, d3, and d4. Thus, an optimal hole diameter corresponding to a predetermined process condition may be selected. The selection of the hole diameter may be dependent upon the plasma density and/or the process result. The process result of the substrate may be confirmed by an analyzing apparatus such as a scanning electron microscope (SEM) or a transmission electron microscope (TEM). The plasma density may be examined by means of Langmuir probe, optical emission spectroscopy (OES), and naked eye.

In modified embodiments, at least one of depth, diameter, and taper angle of holes of the preliminary electrode structure 110 may vary with position. The holes 112a∼112d may have variations in shape.

In modified embodiments, the preliminary electrode structure 110 may not be divided into the first preliminary electrode 114 and the second preliminary electrode 116.

In modified embodiments, the preliminary electrode structure 110 may have variations as long as it includes holes of various shapes.

In modified embodiments, the preliminary electrode structure 110 may include a sputtering protection layer for preventing sputtering caused by plasma. The sputtering protection layer may include at least one of an insulating layer, a conductive layer, and a semiconductor layer.

In modified embodiments, the power for generating plasma is not limited to a power to which the preliminary electrode structure 110 is directly connected and may be applied to an electrode of the preliminary electrode structure 110 or an electrode mounted separately from the preliminary electrode structure 110.

Referring to FIG. 4, the substrate treatment apparatus 100 may include a preliminary electrode structure 110 and a substrate holder 130. A substrate 140 may be disposed on the substrate holder 130. The preliminary electrode structure 110 may include a first preliminary electrode 114 and a second preliminary electrode 116 disposed on one surface of the first preliminary electrode 114. The first preliminary electrode 114 may include holes 212a, 212b, 212c, and 212d whose shapes are different according to positions. The first and second preliminary electrodes 114 and 116 may be electrically connected to each other. Plasma 150 may be generated below the first preliminary electrode 114 by applying an RF power to the second preliminary electrode 116. Under a predetermined process condition, plasma density varying with the shapes of the holes 212a, 212b, 212c, and 212d may be generated to select an optimal shape of a hole. The holes 212a, 212b, 212c, and 212d of the preliminary electrode structure 110 may have depths (t1-t4) which are different according to positions. The holes 212a, 212b, 212c, and 212d of the preliminary electrode structure 110 may have the same diameter (d).

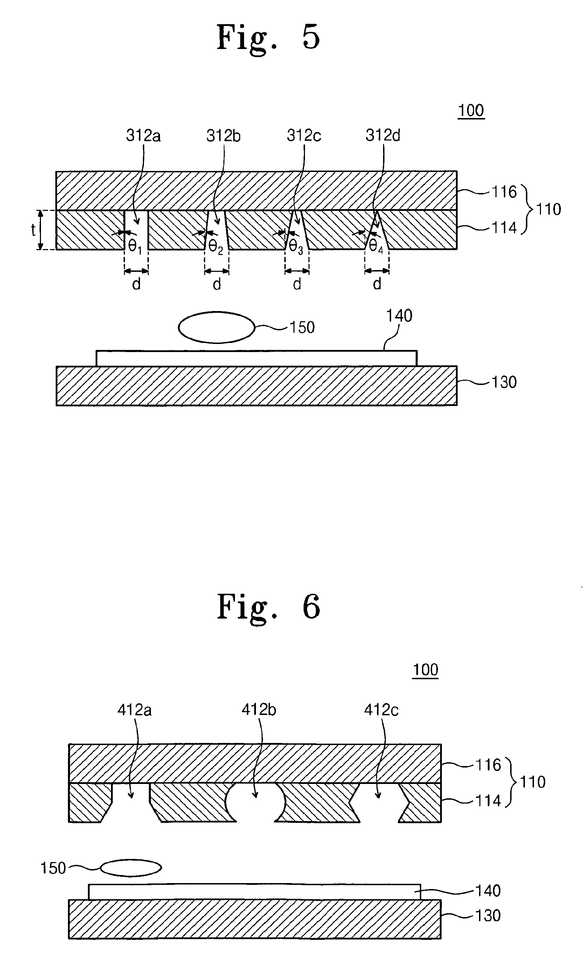

Referring to FIG. 5, the substrate treatment apparatus 100 may include a preliminary electrode structure 110 and a substrate holder 130. A substrate 140 may be disposed on the substrate holder 130. The preliminary electrode structure 110 may include a first preliminary electrode 114 and a second preliminary electrode 116 disposed on one surface of the first preliminary electrode 114. The first preliminary electrode 114 may include holes 312a, 312b, 312c, and 312d whose shapes are different according to positions. The first and second preliminary electrodes 114 and 116 may be electrically connected to each other. Plasma 150 may be generated below the first preliminary electrode 114 by applying an RF power to the second preliminary electrode 116. Under a predetermined process condition, plasma density varying with the shapes of the holes 312a, 312b, 312c, and 312d may be generated to select an optimal shape of a hole.

The holes 312a, 312b, 312c, and 312d of the preliminary electrode structure 110 may have taper angles θ₁, θ₂, θ₃, and θ₄ which are different according to positions.

Referring to FIG. 6, the substrate treatment apparatus 100 may include a preliminary electrode structure 110 and a substrate holder 130. A substrate 140 may be disposed on the substrate holder 130. The preliminary electrode structure 110 may include a first preliminary electrode 114 and a second preliminary electrode 116 disposed on one surface of the first preliminary electrode 114. The first preliminary electrode 114 may include holes 412a, 412b, and 412c whose shapes are different according to positions. The first and second preliminary electrodes 114 and 116 may be electrically connected to each other. Plasma 150 may be generated below the first preliminary electrode 114 by applying an RF power to the second preliminary electrode 116. Under a predetermined process condition, plasma density varying with the shapes of the holes 412a, 412b, and 412c may be generated to select an optimal shape of a hole. The holes 212a, 212b, 212c, and 212d of the preliminary electrode structure 110 may have diameters which are different according to depths.

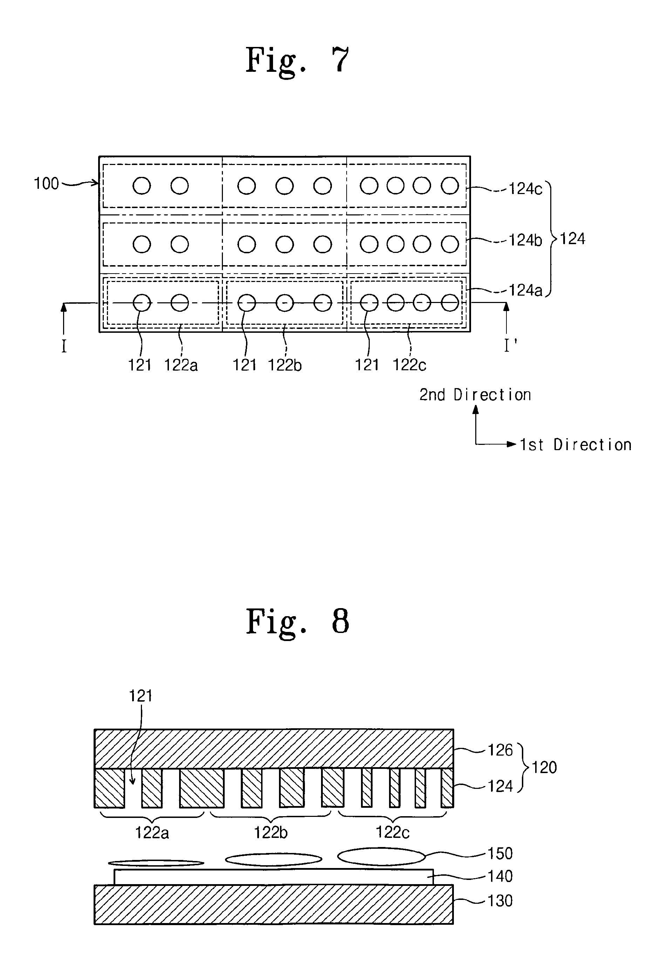

FIGS. 7 and 8 are a plan view and a sectional view of a measuring electrode structure according to an embodiment of the present invention, respectively. Specifically, FIG. 8 is a sectional view taken along the line I-I' in FIG. 7.

Referring to FIGS. 7 and 8, a measuring electrode structure 120 may include a first measuring electrode 124 and a second measuring electrode 126 disposed on one surface of the first measuring electrode 124. The first measuring electrode 124 may have hole density varying with position. The first and second measuring electrodes 124 and 126 may be electrically connected to each other. Plasma may be generated below the first measuring electrode 124 by applying an RF power to the second measuring electrode 126. A non-uniform process and/or non-uniform plasma density may be provided according to the hole density of the first measuring electrode 124.

A substrate holder 130 may be disposed to face the measuring electrode structure 110. A substrate 140 may be mounted on a top surface of the substrate holder 130. The measuring electrode structure 110 may include a plurality of unit measuring electrode patterns 124a, 124b, and 124c. The unit measuring electrode pattern 124a may include a plurality of split areas 122a, 122b, and 122c, which may have different hole densities. The unit measuring electrode patterns 124a, 124b, and 124c may be organized with the same structure. The unit measuring electrode patterns 124a, 124b, and 124c may be fabricated to be separated from each other. For the convenience of description, it is shown that there are 2, 3, and 4 hole densities according to the split areas. However, the hole density may vary with split areas. Alternatively, there may be several to thousands of holes according to split areas. The density of the plasma generated below the split areas 122a, 122b, and 122c and/or a process result of a substrate may be different according to zones. Each of the unit measuring electrode patterns 124a, 124b, and 124c may include a plurality of splits whose combinations are identically selected or differently selected according to positions under the expectation that non-uniformity will appear at the respective positions.

The shape of a hole of the measuring electrode structure 120 may be selected using the preliminary measuring electrode structure described in FIGS. 3 to 6.

In modified embodiments, the split areas 122a, 122b, and 122c may be physically separated from each other.

In modified embodiments, the measuring electrode structure 120 may not be divided into the first measuring electrode 124 and the second measuring electrode 126.

In modified embodiments, the measuring electrode structure 120 may be variously altered as long as it has density varying with position.

In modified embodiments, in the case where it is expected that a process difference will arise according to positions, split combinations based on the unit measuring electrode patterns may be configured to be different according to positions.

In modified embodiments, a power for generating plasma is not limited to a power to which the measuring electrode structure 120 is directly connected and may be applied to an electrode opposite to the measuring electrode structure 120 or an electrode mounted separately from the measuring electrode structure 120.

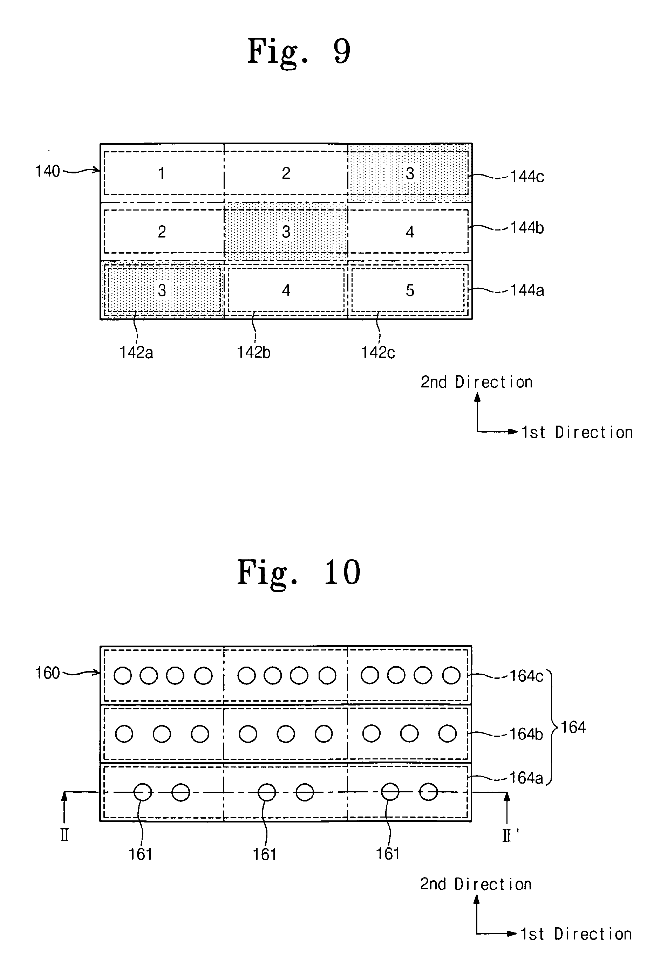

FIG. 9 is a top plan view illustrating a deposition rate when a process is performed for a substrate by using the measuring electrode structure shown in FIG. 7.

Referring to FIGS. 7 and 9, a deposition rate of a substrate 140 may be different according to positions. The substrate 140 may be divided into virtual substrate measuring areas 144a, 144b, and 144c corresponding to unit measuring electrode patterns of the measuring electrode structure 120. The substrate measuring areas 144a, 144b, and 144c may be divided into substrate split areas 142a, 142b, and 142c corresponding to the split areas. Substrate split areas having a deposition rate "3" may be selected at the respective substrate measuring areas 144a, 144b, and 144c. A process electrode structure may be configured such that all areas of the substrate 140 have the deposition rate "3".

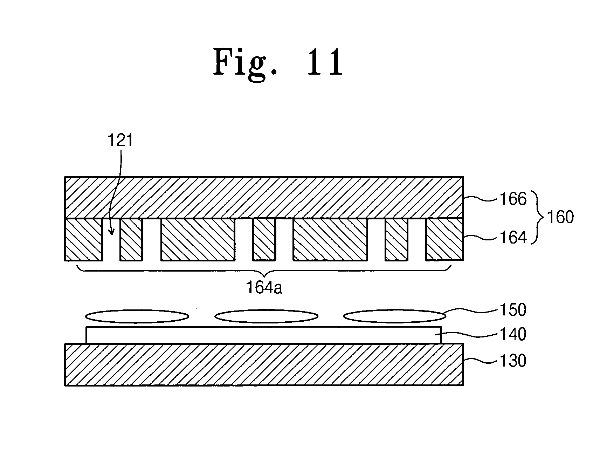

FIGS. 10 and 11 are a top plan view and a cross-sectional view of a process electrode structure according to an embodiment of the present invention, respectively. Specifically, FIG. 11 is a cross-sectional view taken along the line II-II' in FIG. 10.

Referring to FIGS. 7 to 11, a process electrode structure 160 may include a first process electrode 164 and a second process electrode disposed on one surface of the first process electrode 164. The first process electrode 164 may have density of a hole 161 which varies with position. The first and second process electrodes 164 and 166 may be electrically connected to each other. Plasma may be generated below the first process electrode 164 by applying an RF power to the second process electrode 166. The density arrangement based on positions of holes of the first process electrode 166 may be made to compensate process non-uniformity.

The process electrode structure 160 may include a plurality of unit process electrode patterns 164a, 164b, and 164c. The unit process electrode pattern 164a may have the same size as the unit measuring electrode pattern 124a. The density of holes corresponding to an optimal position of the unit measuring electrode may be transferred to the unit process electrode pattern 164a. The unit process electrode patterns 164a, 164b, and 164c may be physically separated from each other.

In modified embodiments, each of the unit process electrode patterns may be provided by combining split areas of a fixed size.

In modified embodiments, the unit process electrode patterns 164a, 164b, and 164c may not be physically separated from each other. That is, the process electrode structure 160 may be fabricated directly on a base substrate.

In modified embodiments, the power for generating plasma is not limited to a power to which the power electrode structure is directly connected and may be applied to an electrode opposite to the process electrode structure or an electrode mounted separately from the process electrode structure.

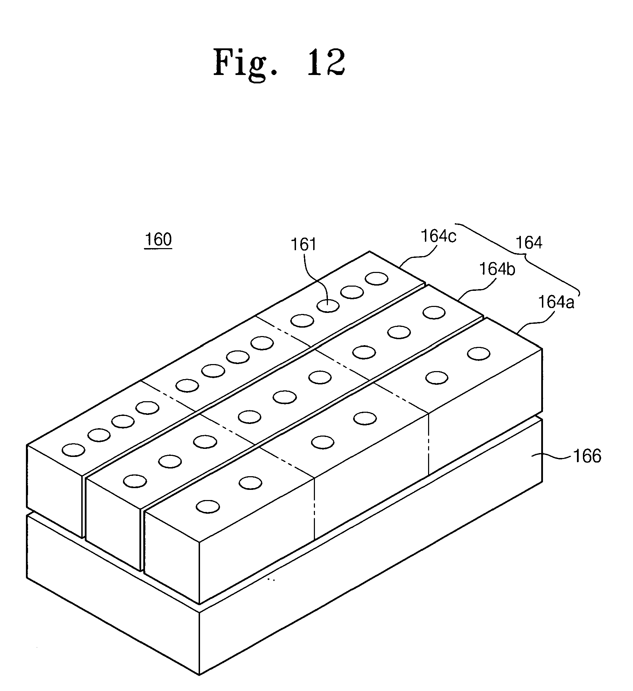

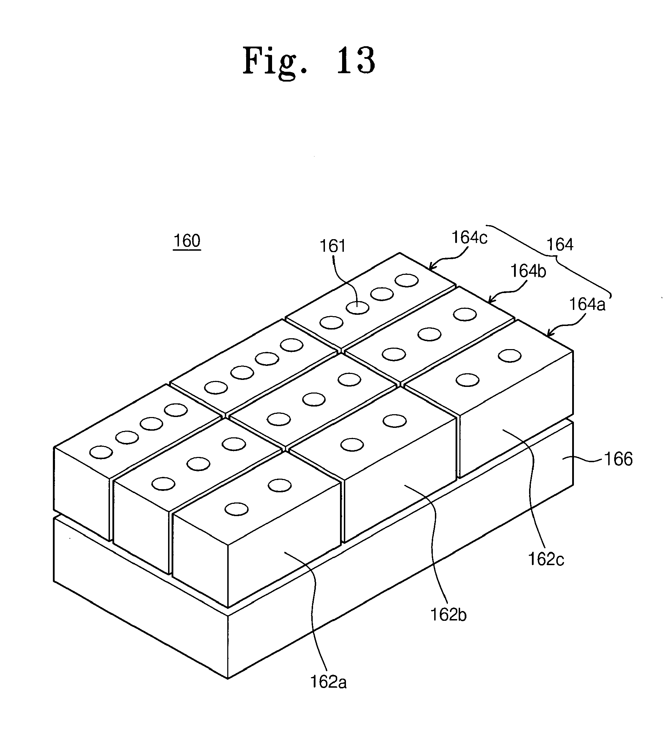

FIGS. 12 to 14 are perspective views of a process electrode structure according to embodiments of the present invention.

Referring to FIGS. 11 and 12, a process electrode structure 160 may include a first process electrode 164 and a second process electrode 166 disposed on one surface of the first process electrode 164. The first process electrode 164 may include a plurality of holes 161, which may lead to hollow cathode discharge. The first process electrode 164 may have hole density varying with position. The first and second electrodes 164 and 166 may be electrically connected to each other. Plasma may be generated below the first process electrode 164 by applying an RF power to the second process electrode 166. The density arrangement based on positions of holes of the first process electrode 164 may be made to compensate process non-uniformity.

The first process electrode 164 may include a plurality of unit process electrodes patterns 164a, 164b, and 164c. The process split areas 162a, 162b, and 162c may be physically separated from each other. The unit process electrode patterns 164a, 164b, and 164c may be fixedly connected to the second process electrode 166.

Referring to FIGS. 10 and 12, a process electrode structure 160 may include a first process electrode 164 and a second process electrode 166 disposed on one surface of the first process electrode 164. The first process electrode 164 may include a plurality of holes 161. The first process electrode 164 may have hole density varying with position. The first and second electrodes 164 and 166 may be electrically connected to each other. Plasma may be generated below the first process electrode 164 by applying an RF power to the second process electrode 166. The density arrangement based on positions of holes of the first process electrode 164 may be made to compensate process non-uniformity.

The first process electrode 164 may include a plurality of unit process electrodes patterns 164a, 164b, and 164c. The unit process electrode pattern 164a may include a plurality of process split areas 162a, 162b, and 162c, which may be physically separated from each other. The unit process electrode patterns 164a, 164b, and 164c may be fixedly connected to the second process electrode 166.

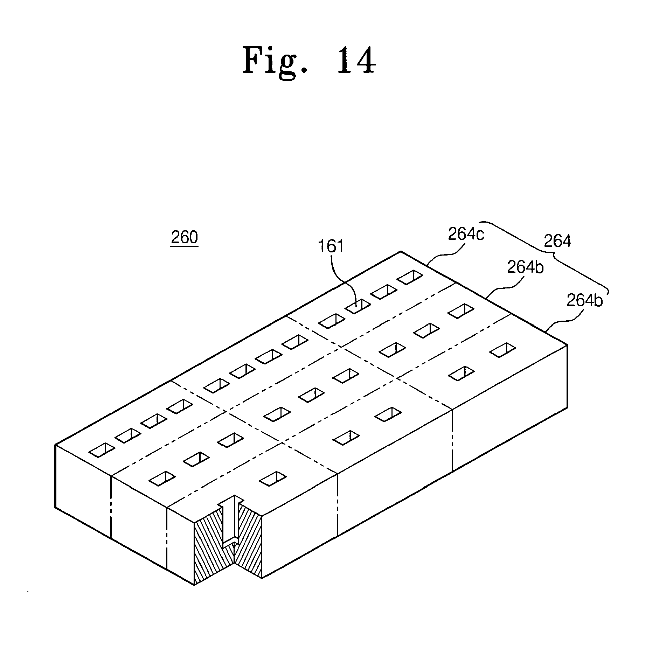

Referring to FIG. 14, a process electrode structure 260 may include a plurality of holes 261, which may lead to hollow cathode discharge. Plasma may be generated below the process electrode structure 260 by applying an RF power to the process electrode structure 260. The density arrangement based on positions of holes of the process electrode structure 260 may be made to compensate process non-uniformity.

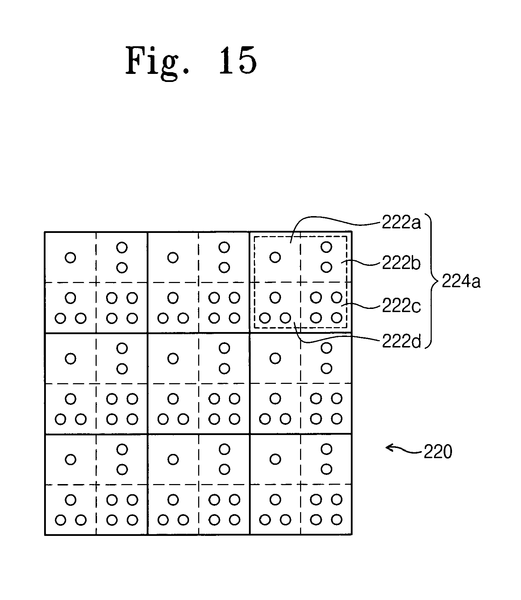

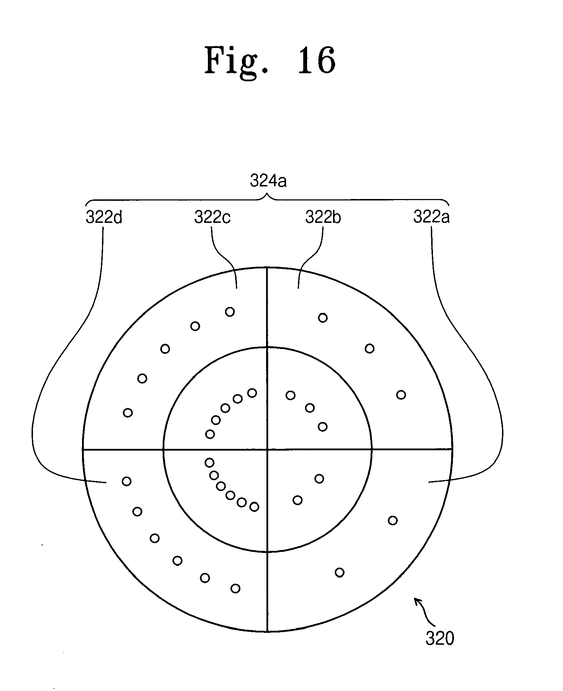

FIGS. 15 and 16 are top plan views of a measuring electrode structure according to embodiments of the present invention.

Referring to FIG. 15, a measuring electrode structure 220 may include a plurality of unit measuring electrode patterns 224a. The measuring electrode structure 220 may be tetragonal. Each of the unit measuring electrode patterns 224a may include a plurality of split areas 222a∼222d, which may have different hole densities. The unit measuring electrode patterns 224a may be physically separated from each other or may be formed directly on one base substrate.

Referring to FIG. 16, a measuring electrode structure 320 may include a plurality of unit measuring electrode patterns 324a. The measuring electrode structure 320 may be circular. Each of the unit measuring electrode patterns 324a may include a plurality of split areas 322a∼322d, which may have different hole densities. The unit measuring electrode patterns 324a may be physically separated from each other or may be formed directly on one base substrate.

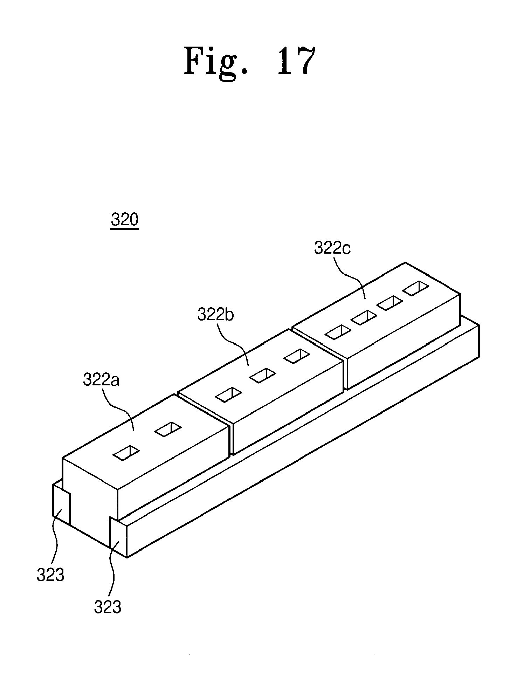

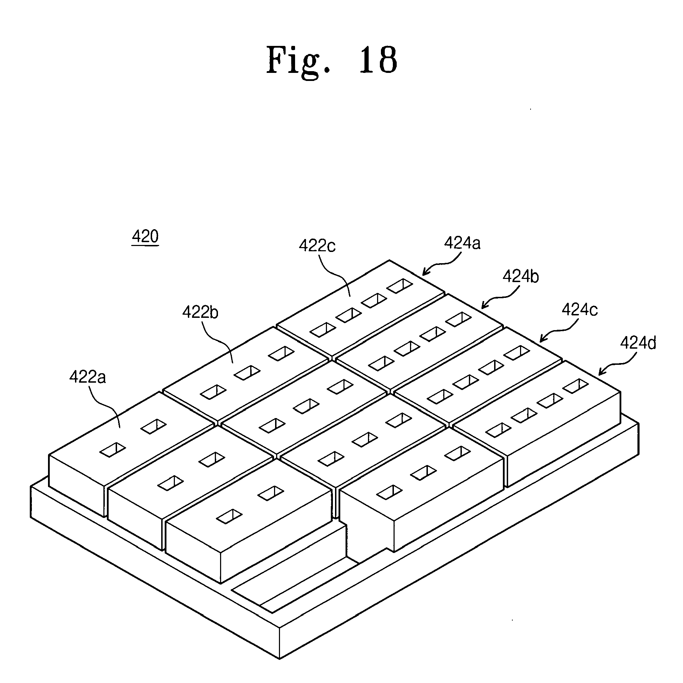

FIGS. 17 and 18 are perspective views of a process electrode structure according to embodiments of the present invention.

Referring to FIG. 17, a measuring electrode structure 320 may have hole density varying with position. Plasma may be generated below the measuring electrode structure 320 by applying a power to the measuring electrode structure 320. Non-uniform process and/or non-uniform plasma density may be provided according to the hole density of the measuring electrode structure 320.

The measuring electrode structure 320 may include at least one unit measuring electrode pattern 322. The unit measuring electrode pattern 322 may include a plurality of split areas 322a, 322b, and 322c, which may different densities. The split areas 322a, 322b, and 322c may be separated from each other and mounted at a guardrail 323.

Referring to FIG. 18, a measuring electrode structure 420 may have hole density varying with position. Plasma may be generated below the measuring electrode structure 420 by applying a power to the measuring electrode structure 420. Non-uniform process and/or non-uniform plasma density may be provided according to the hole density of the measuring electrode structure 420.

The measuring electrode structure 420 may include one or more unit measuring electrode patterns 424a∼424d. Each of the unit measuring electrode patterns 424a∼424d may include a plurality of split areas 422a, 422b, and 422c, which may different densities. The split areas 422a, 422b, and 422c may be separated from each other and mounted at a guardrail 423.

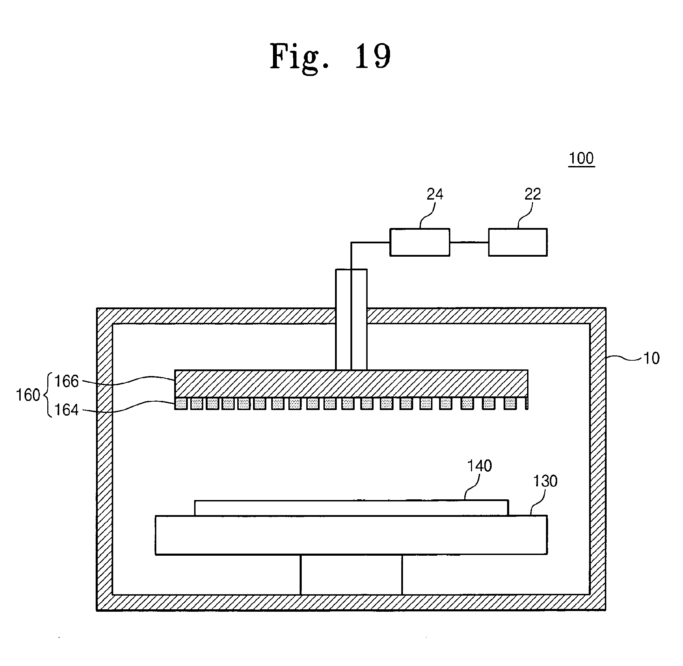

FIGS. 19 to 22 are cross-sectional views of a substrate treatment apparatus according to embodiments of the present invention.

Referring to FIG. 19, a substrate treatment apparatus 100 may include a treatment container 10, a process electrode structure 160 disposed inside the treatment container 10, a power source 22 applying a power to the process electrode structure 160 to generate plasma below the process electrode structure 160, and a substrate holder 130 disposed to face the process electrode structure 160 and configured to hold a substrate 140. The process electrode structure 160 may have hole density varying with positions. Process non-uniformity may be compensated using the process electrode structure 160. A hole of the process electrode structure 160 may lead to hollow cathode discharge.

The substrate treatment apparatus 10 may be subjected to a cleaning process, a deposition process, an etching process, an ion implantation process, an annealing process or a surface treatment process. The treatment container 10 is not limited to a vacuum container. The substrate treatment apparatus 10 may be applied to a roll-to-roll process at atmospheric pressure.

The substrate holder 130 may include at least one of a heater and/or a bias electrode. The substrate holder 130 may be means for holding the substrate 140 or means for applying energy to the substrate 140. The heater may include a cooling unit and supply heat energy to the substrate 140. The bias electrode may be connected to an AC power source, an RF power source or a super-high frequency power source. The substrate holder 130 may supply at least one of ultrasonic energy, light energy, heat energy, magnetic energy, electric energy, and ion energy to the substrate 130.

In case of a deposition process, the process result may be a step coverage, a deposition rate, the quality of a film, a process profile or a composition ratio of a film. In case of an etching process, the process result may be an etch rate, a selectivity, a process profile, the degree of electrical/physical damage on a substrate, the degree of impurities by ion impingement, the thermal effect of annealing or an etch anisotropy.

The process electrode structure 160 may include a first process electrode 164 and a second process electrode 166 disposed on one surface of the first process electrode 164. The first process electrode 164 may has hole density varying with positions. The first and second process electrodes 164 and 166 may be electrically connected to each other. Plasma may be generated below the first process electrode 164 by applying an RF power 22 to the second process electrode 166. A matching circuit 24 may be disposed between the RF power 22 and the process electrode structure 160. The matching circuit 24 may serve to maximally transfer a power of the RF power to a load. The density arrangement based on positions of holes of the first process electrode 164 may be made to compensate process non-uniformity. The process electrode structure 160 may be disposed inside the treatment container 10. A portion of the process electrode structure 160 may be surround by an insulator and/or a conductor to eliminate unnecessary discharge with the treatment container 10.

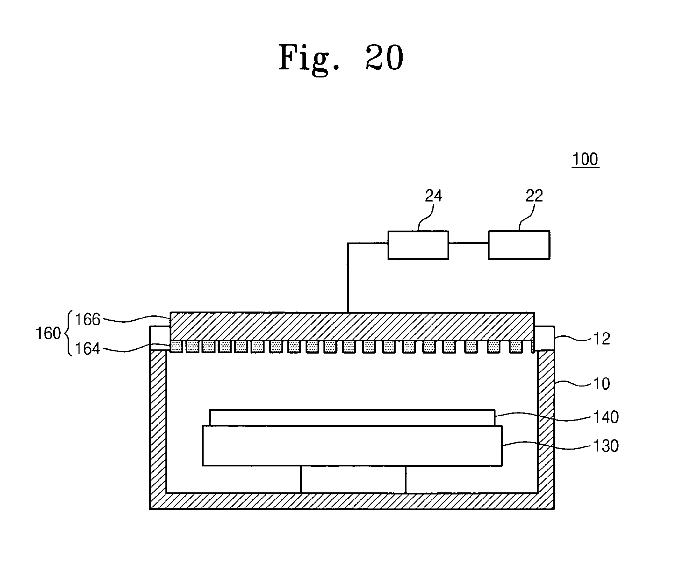

Referring to FIG. 20, a substrate treatment apparatus 100 may include a treatment container 10, a process electrode structure 160 disposed on a sidewall of the treatment container 100, a power source 22 applying a power to the process electrode structure 160 to generate plasma below the process electrode structure 160, and a substrate holder 130 disposed to face the process electrode structure 160 and configured to hold a substrate 140. The process electrode structure 160 may have hole density varying with positions and compensate process non-uniformity based on positions. The process electrode structure 160 may constitute a part of the treatment container 10. The treatment container 10 may include an insulating plate 12, which may be a lid of the treatment container 10. The process electrode structure 160 may be disposed at the insulating plate 12. The insulating plate 12 may insulate the process electrode structure 160 and the container 10 from each other.

The process electrode structure 160 may include a first process electrode 164 and a second process electrode 166 disposed on one surface of the first process electrode 164. The first process electrode 164 may has hole density varying with positions. The first and second process electrodes 164 and 166 may be electrically connected to each other. Plasma may be generated below the first process electrode 164 by applying the power source 22 to the second process electrode 166. A matching circuit 24 may be disposed between the RF power 22 and the process electrode structure 160. The matching circuit 24 may serve to maximally transfer energy of the RF power to a load. The density arrangement based on positions of holes of the first process electrode 164 may be made to compensate process non-uniformity.

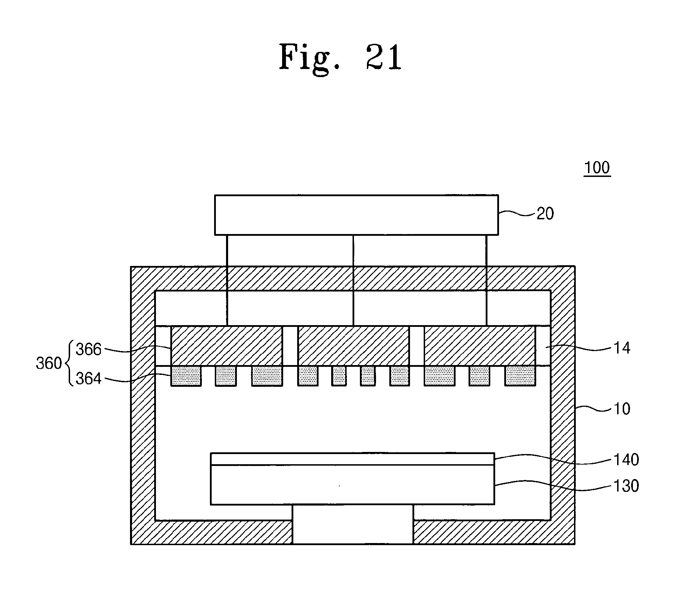

Referring to FIG. 21, a substrate treatment apparatus 100 may include a treatment container 10, a dividing process electrode structure 360 disposed on inside the treatment container 100, a power source 20 applying power to the dividing process electrode structure 360 to generate plasma below the dividing process electrode structure 360, and a substrate holder 130 disposed to face the dividing process electrode structure 360 and configured to hold a substrate 140. The dividing process electrode structure 360 may have hole density varying with positions and compensate process non-uniformity based on positions. The dividing process electrode structure 360 may constitute a part of the treatment container 10. The dividing process electrode structure 360 may be disposed at an insulating plate 14. The insulating plate 14 may insulate dividing process electrode structures 360 from each other.

The dividing process electrode structure 360 may include a first dividing process electrode 364 and a second dividing process electrode 366 disposed on one surface of the first dividing process electrode 364. The first dividing process electrode 364 may has hole density varying with positions. The first and second dividing process electrodes 364 and 366 may be electrically connected to each other. Plasma may be generated below the first dividing process electrode 364 by applying the power source 22 to the second dividing process electrode 166. The density arrangement based on positions of holes of the first spit process electrode 164 may be made to compensate process non-uniformity.

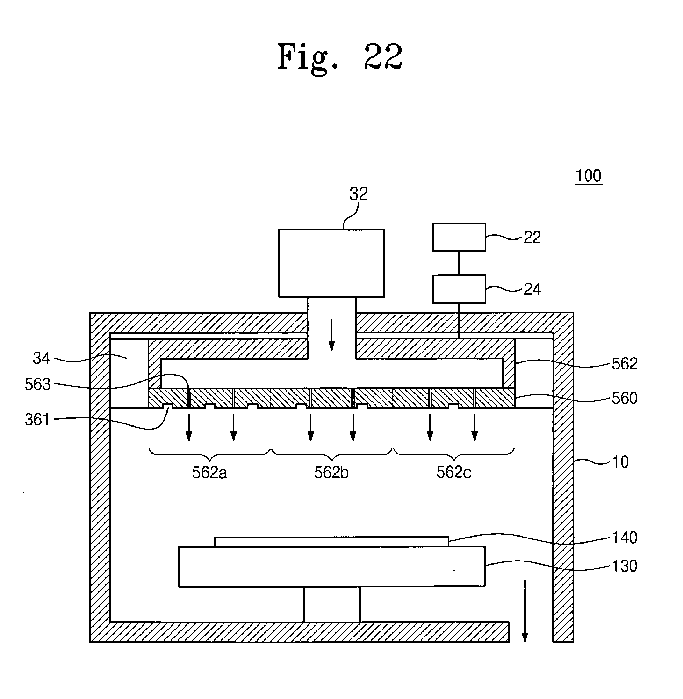

Referring to FIG. 22, a substrate treatment apparatus 100 may include a treatment container 10, a process electrode structure 560 disposed inside the treatment container 100, a power source 22 applying a power to the process electrode structure 560 to generate below the process electrode structure 560, a substrate holder 130 disposed to face the process electrode structure 560 and configured to hold the substrate 140. The process electrode structure 560 may have hole density varying with positions and compensate process non-uniformity based on positions.

The process electrode structure 560 may include a nozzle 563 configured to inject fluid. A fluid dispensing unit 562 is coupled with the process electrode structure 560 to provide a space where fluid may flow. The fluid dispensing unit 562 and the process electrode structure 560 may be electrically connected to each other. Thus, a power applied to the fluid dispensing unit 562 may be transferred to the process electrode structure 560. The fluid dispensing unit 562 may be disposed to surround the process electrode structure 560. An insulating spacer 34 may be disposed to insulate the fluid dispensing unit 562 and the treatment container 10 from each other. The fluid supply unit 32 may supply fluid to the fluid dispensing unit 562. The fluid supplied to the fluid dispensing unit 562 may be supplied to the substrate 140 through the nozzle 563 of the process electrode structure 560.

The process electrode structure 560 may have hole density varying with positions. The process electrode structure 560 may be configured to generate plasma therebelow. A matching circuit 24 may be disposed between the power source 22 and the process electrode structure 160. The matching circuit 24 may serve to maximally transfer a power of an RF power source to a load. The density arrangement based on positions of a hole 561 of the process electrode structure 560 may be made to compensate process non-uniformity.

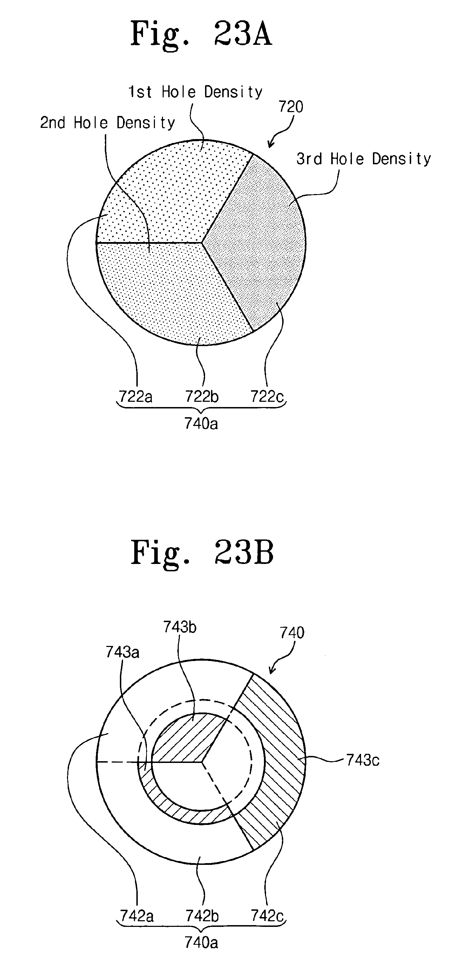

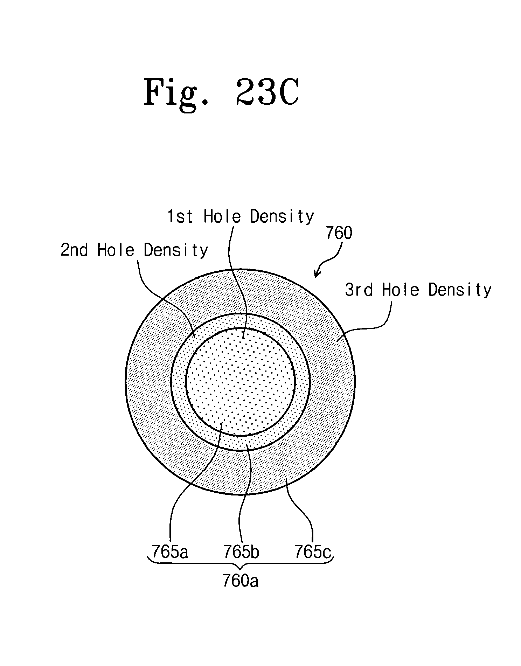

FIGS. 23A to 23C illustrate a substrate treatment method according to another embodiment of the present invention. Explanations duplicated with those in FIGS. 1 and 2 will be omitted.

Referring to FIGS. 23A to 23C, the substrate treatment method may include selecting an optimal process position by treating a substrate with the use of a measuring electrode structure where density of a hole varies with positions, providing a process electrode structure by transferring density of a hole of the measuring electrode structure corresponding to the optimal process position, and compensating process non-uniformity based on positions with the use of the process electrode structure.

A measuring electrode structure 720 may include at least one unit measuring electrode pattern 720a. The unit measuring electrode pattern 720a may include a plurality of split areas 722a, 722b, and 722c. The split areas 722a, 722b, and 722c may have different densities. The split areas 722a, 722b, and 722c may induce plasma characteristics and/or process characteristics varying with positions. Alternatively, plasma characteristics and/or process characteristics on the split area 722a may not be uniform within the split area 722a.

A test process may be performed by treating a substrate 740 with the use of a measuring electrode structure 720. A process result of the substrate 740 based on hole density may be confirmed to select an optimal process position at the substrate 740. The substrate 740 may include unit a unit substrate area 740a, which may correspond to the unit measuring electrode pattern 720a. The unit substrate area 740a may include a plurality of substrate split areas 742a, 742b, and 742c. The substrate split areas 742a, 742b, and 742c may correspond to the split areas 722a, 722b, and 722c of the measuring electrode structure 720, respectively.

The optimal process position may be selected by the unit of split. Alternatively, a split partial area may be selected on optimal process positions 743a, 743b, and 743c may be selected at respective positions on a split as partial areas of the split. The optimal process position may be an area designated within each substrate split area.

A process electrode structure 760 may include at least one unit process electrode pattern 760a. The unit process electrode pattern 760a may have densities of holes corresponding to optimal process positions selected at respective unit measuring electrode patterns. The unit process electrode pattern 760a may have the density arrangement of a hole corresponding to a split where an optimal process is performed at each of the positions on the unit measuring electrode pattern. When a split is divided according to azimuth angle like the unit measuring electrode pattern, it is possible to select splits 743a, 743b, and 743c where an optimal process is performed according to a distance from the center. In case of a tetragonal unit measuring electrode pattern, when a split is divided in the x-direction, it is possible to select a split where an optimal process is performed in the y-direction.

That is, when density of a hole at the optimal process position is transferred, the transferred density may be density of a hole which is relevant to one split on the unit measuring electrode pattern or density of a hole which is relevant to a corresponding split at each position. At the entire area or a partial area of the process electrode structure, the process electrode structure may have a hole corresponding to the measuring electrode structure corresponding to the optimal process position.

The process electrode structure may be fabricated by combining the unit process electrode patterns which are physically separated from each other. Alternatively, the process electrode structure may be fabricated by forming the unit process electrode patterns directly at a base substrate. In the case where a process is performed using the process electrode structure, it may not reach a desired degree of process due to interference effect of an adjacent zone. In this case, the measuring electrode structure and/or the process electrode structure may be re-fabricated by feeding back the process result of the process electrode structure. The process electrode structure may compensate process non-uniformity based on positions to meet an optimal process condition.

To sum up, according to the present invention, an optimal process condition can be rapidly found using a hollow cathode discharge electrode.

Although the present invention has been described in connection with the embodiment of the present invention illustrated in the accompanying drawings, it is not limited thereto. It will be apparent to those skilled in the art that various substitutions, modifications and changes may be made without departing from the scope and spirit of the invention.

## Claims

1. A substrate treatment method comprising:
selecting a shape of a hole by confirming at least one of plasma characteristics and a process result based on the shape of a hole with the use of a preliminary electrode structure where holes are formed to have shapes varying with positions;
selecting an optimal process position by treating a substrate with the use of a measuring electrode structure where density of the hole varies with positions;
providing a process electrode structure by transferring a hole of the measuring electrode structure corresponding to the optimal process position; and
compensating process non-uniformity based on positions with the use of the process electrode structure.

2. The substrate treatment method of claim 1, wherein:
the measuring electrode structure includes one or more unit measuring electrode patterns each including a plurality of split areas having hole density varying with positions.

3. The substrate treatment method of claim 2, wherein:
the optimal process position is selected at each of the unit measuring electrode patterns.

4. The substrate treatment method of claim 3, wherein:
the process electrode structure includes one or more unit process electrode patterns each having density of a hole corresponding to the selected position at each of the unit measuring patterns.

5. The substrate treatment method of claim 4, wherein:
the process electrode structure is fabricated by combining the unit process electrode patterns which are physically separated from each other.

6. The substrate treatment method of claim 4, wherein:
the process electrode structure is fabricated by forming the unit process electrode patterns at a base substrate.

7. The substrate treatment method of claim 1, wherein:
the holes of the preliminary electrode structure are different in at least one of depth, diameter, and taper angle.

8. A substrate treatment method comprising:
selecting an optimal process position by treating a substrate with the use of a measuring electrode structure where density of a hole varies with positions;
providing a process electrode structure by transferring density of a hole of the measuring electrode structure corresponding to the optimal process position; and
compensating process non-uniformity based on positions with the use of the process electrode structure.

9. The substrate treatment method of claim 8, wherein:
the measuring electrode structure includes one or more unit measuring electrode structures each including a plurality of split areas having hole density varying with positions, and
the optimal process position is selected by the unit of split on the unit measuring electrode pattern or selected as a split area according to positions on the unit measuring electrode pattern.

10. A substrate treatment apparatus comprising:
a treatment container;
a process electrode structure disposed on a wall of the treatment container or disposed inside the treatment container;
a power source applying a power to the process electrode structure to generate plasma inside the treatment container; and
a substrate holder disposed to face the process electrode structure and configured to hold a substrate,
wherein the process electrode structure has hole density varying with positions.

11. A preliminary electrode structure comprising:
a first preliminary electrode; and
a second preliminary electrode disposed on one surface of the first preliminary electrode,
wherein the first preliminary electrode holes whose shapes vary with positions, and
the first and second preliminary electrodes are electrically connected to each other, a power is applied to the second preliminary electrode to generate plasma below the first preliminary electrode, and plasma density varying with the shape of a hole of the first preliminary electrode is made under a process condition to select an optimal shape of the hole.

12. A measuring electrode structure comprising:
unit measuring electrode patterns having a plurality of holes,
wherein each of the unit measuring electrode pattern includes a plurality of split areas where densities , diameter, or depth of holes vary with positions, and
the split areas make different plasma densities based on hole density, diameter, or depth varying with positions to provide a non-uniform process according to the hole density.

13. The measuring electrode structure of claim 12, wherein:
the unit measuring electrode patterns are separated or combined.

14. A process electrode structure comprising:
at least one unit process electrode pattern having a plurality of holes,
wherein the unit process electrode pattern make uniform plasma density based on hole density, diameter, or depth varying with positions to provide a uniform process according to the hole density.

15. The process electrode structure of claim 14, further comprising:
a nozzle configured to inject fluid.
